# EUROPEAN PATENT APPLICATION

(11) **EP 4 708 294 A1**
(43) Date of publication of application: **11.03.2026**
(21) Application number: 24861451.3
(22) Date of filing: 26.02.2024
(51) Int. Cl.: G11C 5/06

(54) **SEMICONDUCTOR DEVICE AND PREPARATION METHOD THEREFOR, AND ELECTRONIC DEVICE**

(30) Priority: 05.09.2023 CN 202311138443
(71) Applicant: Beijing Superstring Academy of Memory Technology, Beijing 100176 (CN)
(72) Inventor: WANG, Xiangsheng, Beijing 100176 (CN); LI, Gengfei, Beijing 100176 (CN); DAI, Jin, Beijing 100176 (CN); LIU, Mingxu, Beijing 100176 (CN); WANG, Guilei, Beijing 100176 (CN); ZHAO, Chao, Beijing 100176 (CN)
(74) Representative: Lavoix
(86) International application number: PCT/CN2024/078599
(87) International publication number: WO 2025/050600

(57) **Abstract**

Provided are a semiconductor device and a preparation method therefor and an electronic device. The semiconductor device comprises a substrate, and a storage part, a wiring part, and a peripheral circuit part which are arranged on one side of the substrate; the positions of the storage part, the wiring part, and the peripheral circuit part are different in a direction perpendicular to the substrate; the storage part comprises at least two sub-storage arrays, and the at least two sub-storage arrays are sequentially arranged in a first direction parallel to the substrate; each sub-storage array comprises at least one storage unit, and the storage unit comprises a transistor; the wiring part comprises at least one shared word line; and in the at least two sub-storage arrays, the gates of the transistors of the storage units located in different sub-storage arrays are electrically connected to the same shared word line, and the shared word line is connected to the peripheral circuit part.

## Description

### CROSS-REFERENCE TO RELATED APPLICATION

This application claims the priority of Chinese Patent Application No. 202311138443.2, filed on September 05, 2023 and entitled "SEMICONDUCTOR DEVICE AND PREPARATION METHOD THEREFOR, AND ELECTRONIC DEVICE", which is incorporated herein by reference in its entirety.

### TECHNICAL FIELD

The present disclosure relates to the technical field of semiconductors, and in particular to a semiconductor device, and a preparation method therefor, and an electronic device.

### BACKGROUND

Memory is the main medium for data storage in computers. With the development and advancement of memory technology, memory devices are continuously evolving towards miniaturization, higher device density, and high integration.

### SUMMARY

The disclosure provides a semiconductor device, a preparation method therefor and an electronic device.

In the first aspect, the embodiment of the disclosure provides a semiconductor device, which includes a substrate; and a memory portion, a wiring portion, and a peripheral circuit portion disposed on one side of the substrate. The memory portion, the wiring portion, and the peripheral circuit portion are located at different positions in a direction perpendicular to the substrate. The memory portion includes at least two sub-memory arrays arranged sequentially along a first direction parallel to the substrate. Each sub-memory array includes at least one memory cell, and the memory cell includes a transistor. The wiring portion includes at least one shared word line.

Among the at least two sub-memory arrays, gates of transistors in memory cells located in different sub-memory arrays are electrically connected to the same shared word line, and the shared word line is connected to the peripheral circuit portion.

In some optional implementations of the disclosure, gates of transistors in memory cells located at the same corresponding positions in the different sub-memory arrays are electrically connected to the same shared word line.

In some optional implementations of the disclosure, the wiring portion further includes at least two shared bit lines, and the at least two shared bit lines are connected to the at least two sub-memory arrays in a one-to-one correspondence.

In some optional implementations of the disclosure, the sub-memory array includes a local bit line, a gating structure, and multiple memory cells, and the multiple memory cells are arranged sequentially along a second direction parallel to the substrate.

The local bit line is electrically connected to sources or drains of transistors in the multiple memory cells, respectively, and the local bit line is electrically connected to the gating structure to form a memory cell column.

The gating structure is electrically connected to the corresponding shared bit line.

Herein, the second direction intersects with the first direction, that is, the second direction is set at an angle to the first direction.

In some optional implementations of the disclosure, multiple shared word lines, which are connected to the multiple memory cells in the same sub-memory array in a one-to-one correspondence, are located in a same wiring layer, this wiring layer is parallel to the substrate; and within this wiring layer, the multiple shared word lines are sequentially arranged along the second direction.

In some optional implementations of the disclosure, the sub-memory array has at least two memory cell columns, and the at least two memory cell columns are sequentially arranged along a first direction.

At least two memory cell columns of the same sub-memory array are electrically connected with the same corresponding shared bit line.

Among the at least two memory cell columns of the same sub-memory array, shared word lines correspondingly connected to different memory cell columns are located in different wiring layers; and at least two wiring layers correspondingly connected to the at least two memory cell columns are sequentially arranged along the direction perpendicular to the substrate.

In some optional implementations of the disclosure, the memory cell includes a first transistor and a second transistor, and the source or drain of the first transistor and the source or drain of the second transistor are both electrically connected to a local bit line.

The shared word line correspondingly connected with the memory cell includes a first sub-shared word line and a second sub-shared word line. herein, the first sub-shared word line is electrically connected to the gate of the first transistor, and the second sub-shared word line is electrically connected to the gate of the second transistor.

The first sub-shared word line and the second sub-shared word line are located in the same wiring layer; within the wiring layer, the first sub-shared word line and the second sub-shared word line are arranged at intervals along the second direction and are staggered in the first direction.

In some optional implementations of the disclosure, the at least two sub-memory arrays are located in a same memory array layer, and the memory portion has multiple memory array layers stacked sequentially in the direction perpendicular to the substrate; the multiple memory array layers satisfy at least one of following conditions:
among the multiple memory array layers, respective sub-memory arrays whose orthographic projections on the substrate overlap are electrically connected to the same shared bit line; and
among the multiple memory array layers, gates of transistors of respective memory cells whose orthographic projections on the substrate overlap are electrically connected to the same shared word line.

In some optional implementations of the disclosure, the peripheral circuit portion includes a word line driver circuit, and the shared word line is electrically connected to the word line driver circuit.

An orthographic projection of the word line driver circuit on the substrate and an orthographic projection of the shared word line on the substrate both overlap with an orthographic projection of the correspondingly connected memory cell on the substrate.

In some optional implementations of the disclosure, there are multiple sub-memory arrays, and the multiple sub-memory arrays arranged sequentially along the first direction are grouped into the at least two memory arrays.

The gates of transistors of memory cells located at the same corresponding positions in respective sub-memory arrays of the same memory array are electrically connected to the same shared word line.

The gates of transistors in memory cells located at the same corresponding positions in sub-memory arrays of different memory arrays are electrically connected to the same shared word line.

The gates of transistors in memory cells located at the same corresponding positions in sub-memory arrays of different memory arrays are respectively electrically connected to different shared word lines.

In some optional implementations of the disclosure, gates of transistors in memory cells located at the same corresponding positions in sub-memory arrays of different memory arrays are respectively electrically connected to different shared word lines.

The word line driver circuit includes at least two sub-word line driver circuits, and the at least two sub-word line driver circuits are connected to the at least two memory arrays in a one-to-one correspondence; and/or
at least two shared word lines, which are respectively electrically connected to the gates of the transistors in the memory cells located at the same corresponding positions in the sub-memory arrays of the different memory arrays, are located in the same wiring layer or in different wiring layers.

In some optional implementations of the disclosure, the peripheral circuit portion includes a word line driver circuit, and the first sub-shared word line and the second sub-shared word line, which are respectively connected to the same memory cell, are respectively connected to different positions of the same word line driver circuit.

In some optional implementations of the disclosure, the peripheral circuit portion further includes at least two sense amplifier circuits connected to the at least two shared bit lines in a one-to-one correspondence.

The orthographic projection of each of the sense amplifier circuits on the substrate overlaps with an orthographic projection of the correspondingly connected shared bit line on the substrate.

In some optional implementations of that disclosure, the peripheral circuit portion includes a word line driver circuit, and the word line driver circuit includes multiple sites arranged in a matrix.

Shared word lines located in the same wiring layer are respectively connected to different sites in the same column of the word line driver circuit, and shared word lines located in different wiring layers are respectively connected to sites in different columns of the word line driver circuit.

In some optional implementations of the disclosure, the memory portion, the wiring portion, and the peripheral circuit portion are sequentially arranged in a direction away from the substrate; or
the peripheral circuit portion, the wiring portion, and the memory portion are sequentially arranged in a direction away from the substrate.

In the second aspect, the embodiment of the disclosure provides a method for preparing a semiconductor device, which is used for preparing the semiconductor device provided in the above aspect. The preparation method includes that: a substrate is provided; and the memory portion, wiring portion, and peripheral circuit portion are form on one side of the substrate. Herein, in the direction perpendicular to the substrate, the memory portion, wiring portion, and peripheral circuit portion are located at different positions. The memory portion includes at least two sub-memory arrays arranged sequentially along a first direction parallel to the substrate. Each sub-memory array includes at least one memory cell, and each memory cell includes a transistor.

The wiring portion includes at least one shared word line. Among the at least two sub-memory arrays, the gates of transistors of memory cells located in different sub-memory arrays are electrically connected to the same shared word line, and the shared word line is connected to the peripheral circuit portion.

In a third aspect, the embodiment of the disclosure provides an electronic device, which includes the above semiconductor device.

### BRIEF DESCRIPTION OF THE DRAWINGS

FIG. 1a is a schematic structural diagram of an optional example of a semiconductor device according to an embodiment of the present disclosure.
FIG. 1b is another schematic structural diagram of the semiconductor device in FIG. 1a.
FIG. 2 is a schematic structural diagram of another optional example of a semiconductor device according to an embodiment of the present disclosure.
FIG. 3a is a schematic structural diagram of yet another optional example of a semiconductor device according to an embodiment of the present disclosure.
FIG. 3b is a schematic structural diagram of still another optional example of a semiconductor device according to an embodiment of the present disclosure.
FIG. 4 is a top-view schematic structural diagram of a part of the structure of a semiconductor device according to an embodiment of the present disclosure.
FIG. 5 is a top-view schematic structural diagram of a semiconductor device according to an embodiment of the present disclosure.
FIG. 6 is a top-view schematic structural diagram of a part of the structure of a semiconductor device according to an embodiment of the present disclosure.
FIG. 7 is a schematic structural diagram of a semiconductor device according to an embodiment of the present disclosure.
FIG. 8 is another schematic structural diagram of a semiconductor device according to an embodiment of the present disclosure.
FIG. 9 is yet another schematic structural diagram of a semiconductor device according to an embodiment of the present disclosure.
FIG. 10 is still another schematic structural diagram of a semiconductor device according to an embodiment of the present disclosure.
FIG. 11 is a flowchart of a preparation method for a semiconductor device according to an embodiment of the present disclosure.

### Reference numeral:

100 - semiconductor device; 20 - memory portion; 21 - memory array layer; 211 - sub-memory array; 212 - memory cell; 213 - local bit line; 214 -- gating structure; 215 - memory cell column; 216 - first transistor; 217 - second transistor; 218 - word line; 22 - memory array; 30 - wiring portion; 31 - shared bit line; 32 - shared word line; 321 - first sub-shared word line; 322 - second sub-shared word line; 33 - wiring layer; 40 - peripheral circuit portion; 41 - word line driver circuit; 411 - Sub-word line driver circuit; 412 - first word line driver circuit; 413 - second word line driver circuit; 42 - sense amplifier circuit.

### DETAILED DESCRIPTION

The following describes embodiments of the present disclosure with reference to the accompanying drawings. It should be understood that the embodiments described below with reference to the drawings are illustrative descriptions intended to explain the technical solutions of the embodiments of the present disclosure and do not constitute limitations on the technical solutions of the embodiments of the present disclosure.

Those skilled in the art will understand that unless specifically stated otherwise, the singular forms "one," "a," "the," and "said" used herein may also include plural forms. It should be further understood that the term "including" used in the description of the present disclosure refers to the presence of the stated features, integers, steps, operations, elements, and/or components, but does not exclude the presence of other features, information, data, steps, operations, elements, components, and/or combinations thereof supported by the technical field . It should be understood that when an element is described as being "connected" or "coupled" to another element, the element may be directly connected or coupled to the other element, or may establish a connection relationship with the other element through an intermediate element. Furthermore, the terms "connected" or "coupled" used herein may include wireless connection or wireless coupling. The term "and/or" used herein refers to at least one of the items defined by the term. For example, "A and/or B" may be implemented as "A," as "B," or as "A and B."

To make the objectives, technical solutions, and advantages of the present disclosure clearer, the embodiments of the present disclosure will be described in further detail below with reference to the accompanying drawings.

The following describes some embodiments of memory devices.

With the continuous increase in demands for device density and integration among various types of memory devices, three-dimensional (3D) memory devices have emerged. 3D memory devices enable data storage and transmission in a three-dimensional space, significantly enhancing storage capacity of memory devices, reducing storage costs, improving integration and storage density, thereby facilitating the miniaturization of memory devices.

Three-dimensional memory devices employ a stacked structure to increase density and integration. However, setting up such a stacked structure necessitates the introduction of numerous metal lines to connect to peripheral circuits. If the conventional connection method-where each transistor connects to the peripheral circuit through a single word line-is adopted, it would result in substantial area occupied by the wiring and peripheral circuits, which will lead to the three-dimensionalization of the memory array area losing its significance of improving density and integration.

The semiconductor device, its preparation method, and electronic device according to the embodiments of the disclosure aim to address the aforementioned technical issues.

The technical solutions of the embodiments of the disclosure and how these technical solutions address the aforementioned technical issues are detailed below through specific embodiments. It should be noted that the embodiments described below may reference, draw upon, or be combined with one another; identical terms, similar features, and similar implementation steps across different embodiments will not be described repeatedly.

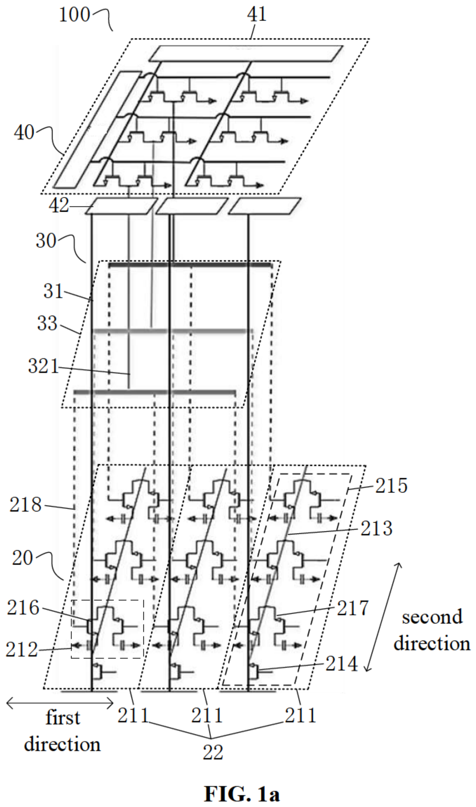

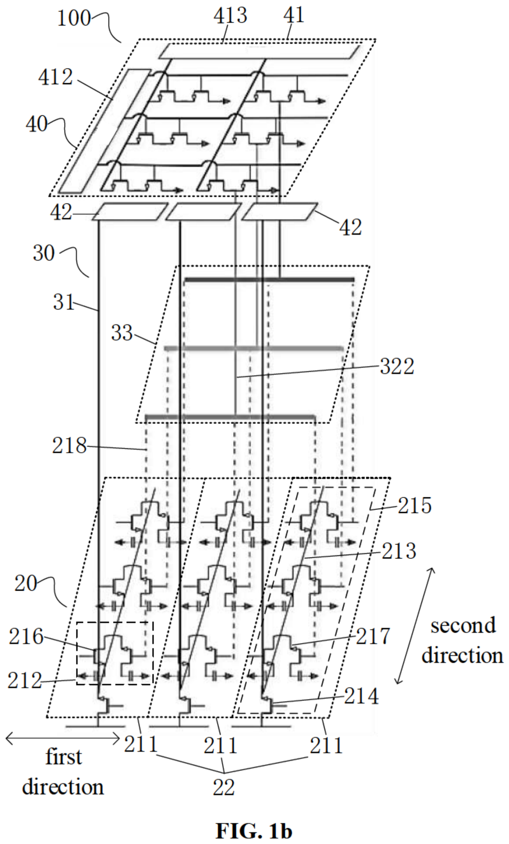

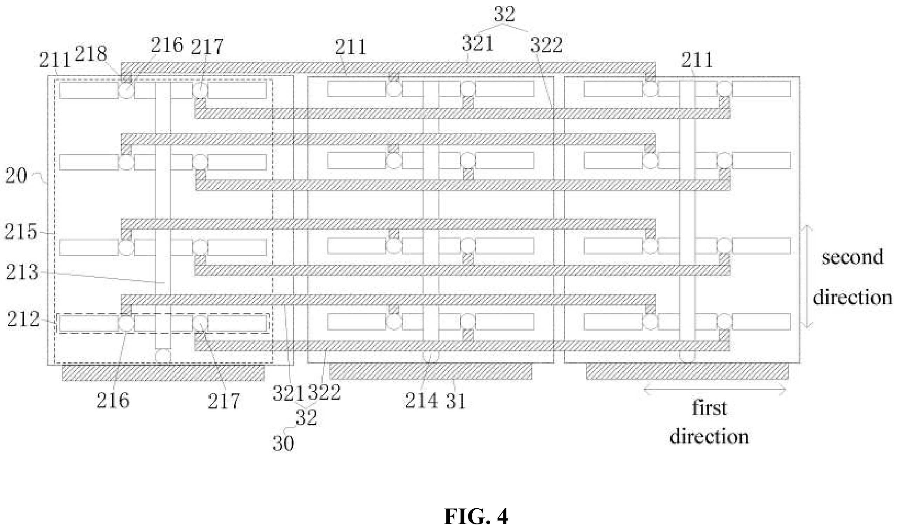

The embodiments of present disclosure provides a semiconductor device, which may be a memory device. The schematic structural diagrams of the semiconductor device 100 are illustrated in FIG. 1 to FIG. 10. Referring to FIG. 1a to FIG. 3b, the semiconductor device 100 includes: a substrate; and a memory portion 20, a wiring portion 30, and a peripheral circuit portion 40 which are disposed on one side of the substrate. In the direction perpendicular to the substrate, the memory portion 20, the wiring portion 30, and the peripheral circuit portion 40 are located at different positions. The memory portion 20 includes at least two sub-memory arrays 211, which are sequentially arranged along a first direction parallel to the substrate. Each sub-memory array 211 includes at least one memory cell 212, and each memory cell 212 includes a transistor. The wiring portion 30 includes at least one shared word line 32. Among the at least two sub-memory arrays 211, the gates of transistors of memory cells 212 located in different sub-memory arrays 211 are electrically connected to the same shared word line 32, and the shared word line 32 is connected to the peripheral circuit portion 40.

In the embodiments of the present disclosure, the substrate provides support for the memory portion 20, the wiring portion 30, and the peripheral circuit portion 40. Arranging the memory portion 20, the wiring portion 30, and the peripheral circuit portion 40 at different positions in the direction perpendicular to the substrate facilitates reasonable space allocation and reduces the occupied area.

In the embodiment of the present disclosure, at least two sub-memory arrays 211 included in the memory portion 20 are sequentially arranged along the first direction parallel to the substrate, which facilitates the arrangement of at least two sub-memory arrays 211 and avoids interference.

In the embodiment of the present disclosure, each sub-memory array 211 includes at least one memory cell 212, and the wiring portion 30 includes at least one shared word line 32. The at least one shared word line 32 is in a one-to-one correspondence with at least one memory cell 212 in any one of the sub-memory arrays 211. Furthermore, among the at least two sub-memory arrays 211, the gates of transistors in memory cells 212 located in different sub-memory arrays 211 are electrically connected to the same shared word line 32. That is, among the at least two sub-memory arrays 211 included in the memory portion 20, transistors of memory cells 212 located in different sub-memory arrays 211 can share a single shared word line 32, and can be connected to the peripheral circuit portion 40 through this shared word line 32. Compared with conventional technology where one transistor is connected to the peripheral circuit through one word line, the embodiments of the present disclosure can significantly reduce the wiring and decrease peripheral circuit area by using shared word lines, without occupying additional area, thereby improving device density and integration.

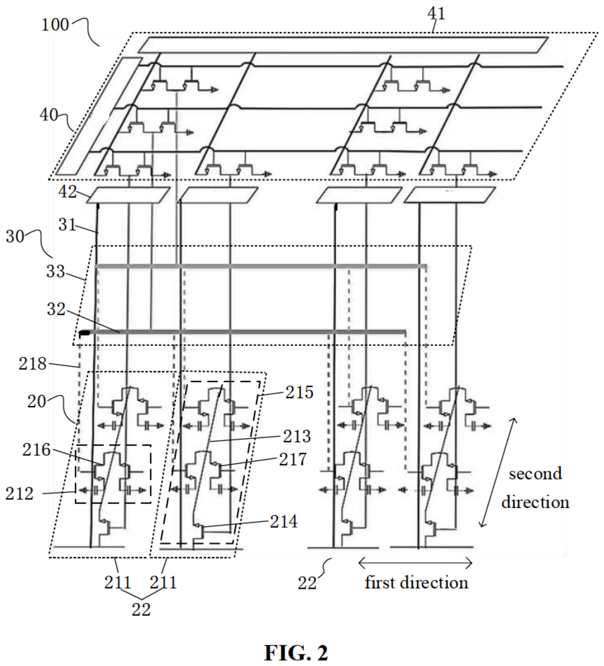

In some optional implementations of the present disclosure, as illustrated in FIG. 2, among the at least two sub-memory arrays 211, the gates of transistors in memory cells 212 located at the same corresponding positions in different sub-memory arrays 211 are electrically connected to the same shared word line 32. Specifically, among at least two sub-memory arrays 211 within the memory portion 20, the gates of transistors in memory cells 212 located at the same corresponding positions in different sub-memory arrays 211 can share a single shared word line 32, and can be connected to the peripheral circuit portion 40 through this shared word line 32. The embodiments of the present disclosure can significantly reduce wiring and decrease the peripheral circuit area by using shared word lines, without occupying additional area, thereby improving device density and integration. Furthermore, by enabling transistors of memory cells 212 located at the same corresponding positions in different sub-memory arrays 211 to share one shared word line 32, it can facilitate reasonable arrangement of wirings and avoid clutter.

Of course, in some other optional implementations of the present disclosure, the gates of transistors in memory cells 212 located at different corresponding positions in different sub-memory arrays 211 may also be electrically connected to the same shared word line 32 according to actual needs.

It should be understood that a position of a memory cell 212 in the sub-memory array 211 may be represented by coordinates (M, N), where M represents the row and N represents the column, and both M and N may be integers greater than or equal to 1. A memory cell 212 with coordinates (M, N) indicate that the position of this memory cell 212 is in the M-th row and N-th column of the sub-memory array 211. In the embodiments of the present disclosure, "the transistors of the memory cells 212 at the same corresponding positions in different sub-memory arrays 211 among the at least two sub-memory arrays 211" include: the transistors of all memory cells 212 with coordinates (M, N) in different sub-memory arrays 211 among the at least two sub-memory arrays 211. The embodiments of the present disclosure takes an example where the memory portion 20 includes two sub-memory arrays 211 and each sub-memory array 211 includes four memory cells 212 arranged in an array, that is, takes the case where M = N = 2 as an example for illustration:

The coordinates of the four memory cells 212 in each sub-memory array 211 are (1, 1), (1, 2), (2, 1), and (2, 2), respectively. In the two sub-memory arrays 211, the transistors of memory cells 212 located at the same corresponding positions in different sub-memory arrays 211 refer to:
the transistors of the memory cells 212 with coordinates (1,1) in the two sub-memory arrays 211, that is, the transistors of the memory cells 212 located in the first row and the first column in the two sub-memory arrays 211; or,
the transistors of the memory cells 212 with coordinates (1,2) in the two sub-memory arrays 211, that is, the transistors of the memory cells 212 located in the first row and the second column in the two sub-memory arrays 211; or,
the transistors of the memory cells 212 with coordinates (2,1) in the two sub-memory arrays 211, that is, the transistors of the memory cells 212 located in the second row and the first column in the two sub-memory arrays 211; or,
the transistors of the memory cells 212 with coordinates (2,2) in the two sub-memory arrays 211, that is, the transistors of the memory cells 212 located in the second row and the second column in the two sub-memory arrays 211.

It should also be understood that the meaning of "the same corresponding positions" used in the following parts of the disclosure is similar to the explanation of the meaning of "the same corresponding positions" above, and will not be repeated here.

Optionally, in the embodiments of the present disclosure, as illustrated in FIG. 1a to FIG. 3b, the gate of the transistor of the memory cell 212 is electrically connected to the shared word line 32 through the word line 218 correspondingly connected to this transistor.

In some optional implementations of the present disclosure, as illustrated in FIG. 2, the wiring portion 30 includes at least two shared bit lines 31 that are connected to at least two sub-memory arrays 211 in a one-to-one correspondence.

In the embodiment of the present disclosure, at least two shared bit lines 31 of the wiring portion 30 are connected to at least two sub-memory arrays 211 in a one-to-one correspondence, and different sub-memory arrays 211 are respectively connected to different shared bit lines 31 in a one-to-one correspondence. Through the shared bit lines 31, data can be read from the memory cells 212 in the corresponding sub-memory array 211 or written into the memory cells 212 in the corresponding sub-memory array 211.

Optionally, in the embodiments of the present disclosure, both the shared word lines 32 and the shared bit lines 31 may be made of metallic materials.

In some optional implementations of the present disclosure, as illustrated in FIG. 2, the sub-memory array 211 includes a local bit line 213, a gating structure 214, and multiple memory cells 212. The multiple memory cells 212 are sequentially arranged along a second direction parallel to the substrate. The local bit line 213 is also arranged along this second direction. The local bit line 213 is electrically connected to the sources or drains of transistors of the multiple memory cells 212 respectively, and the local bit line 213 is electrically connected to the gating structure 214, to form a memory cell column 215. That is, the memory cell column 215 includes the local bit line 213, the transistors of the multiple memory cells 212 and the gating structure 214 that are electrically connected to the local bit line 213. The gating structure 214 is electrically connected to the corresponding shared bit line 31. The second direction intersects with the first direction, that is, the second direction is set at an angle to the first direction.

In the embodiments of the present disclosure, the multiple memory cells 212 are arranged sequentially along the second direction, which facilitates the arrangement and can avoid interference. Each sub-memory array 211 is correspondingly connected to one shared bit line 31. In a sub-memory array 211, the sources or drains of the transistors of the multiple memory cells 212 are all electrically connected to the local bit line 213, and the local bit line 213 is electrically connected to the gating structure 214, forming the memory cell column 215. The gating structure 214 is electrically connected to the corresponding shared bit line 31, achieving the electrical connection between the memory cell column 215 and the shared bit line 31.

In the embodiment of the present disclosure, as illustrated in FIG. 2, the gates of transistors of multiple memory cells 212 in the same sub-memory array 211 are respectively in one-to-one correspondence with and electrically connected to different shared word lines 32. The gates of transistors in memory cells 212 located at the same corresponding positions in different sub-memory arrays 211 are electrically connected to the same shared word line 32. Through the shared word line 32, the turning on or off of transistor of memory cells 212 located at the same corresponding positions in different sub-memory arrays 211 can be controlled.

Each sub-memory array 211 is correspondingly connected to one shared bit line 31. Through the shared bit line 31, data can be read from the memory cells 212 in the corresponding sub-memory array 211 or written into the memory cells 212 in the corresponding sub-memory array 211. The gating structure 214 is configured to write multiple data signals into respective memory cells 212 in a one-to-one correspondence under the control of signals from multiple shared word lines 32.

Optionally, in some embodiments of the present disclosure, the second direction is perpendicular to the first direction.

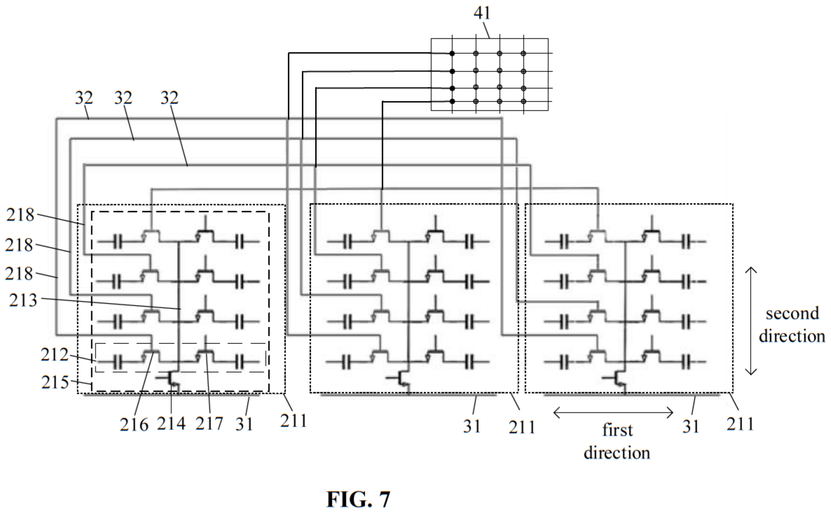

In some optional implementations of the present disclosure, as illustrated in FIG. 2 and FIG. 7, multiple shared word lines 32 that are connected in one-to-one correspondence with transistors of multiple memory cells 212 in the same sub-memory array 211, are located in the same wiring layer 33. Optionally, this wiring layer 33 is parallel to the substrate. Within the wiring layer 33, the multiple shared word lines 32 are sequentially arranged along the second direction. This design approach enables reasonable arrangement of wirings, simplifies the structure of the wiring portion 30, avoids clutter, helps save peripheral circuit area, and improves device density and integration.

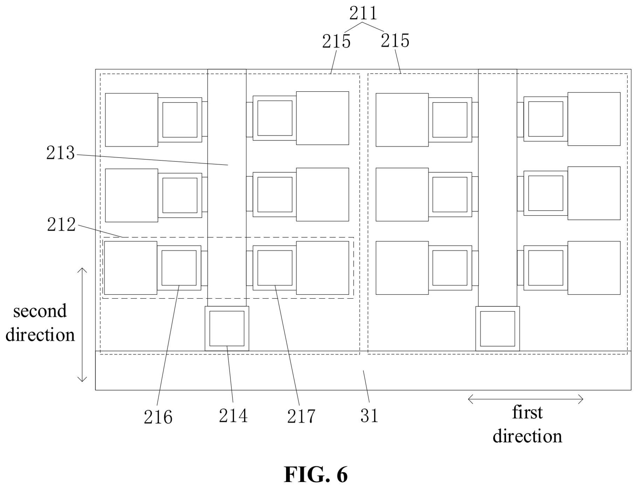

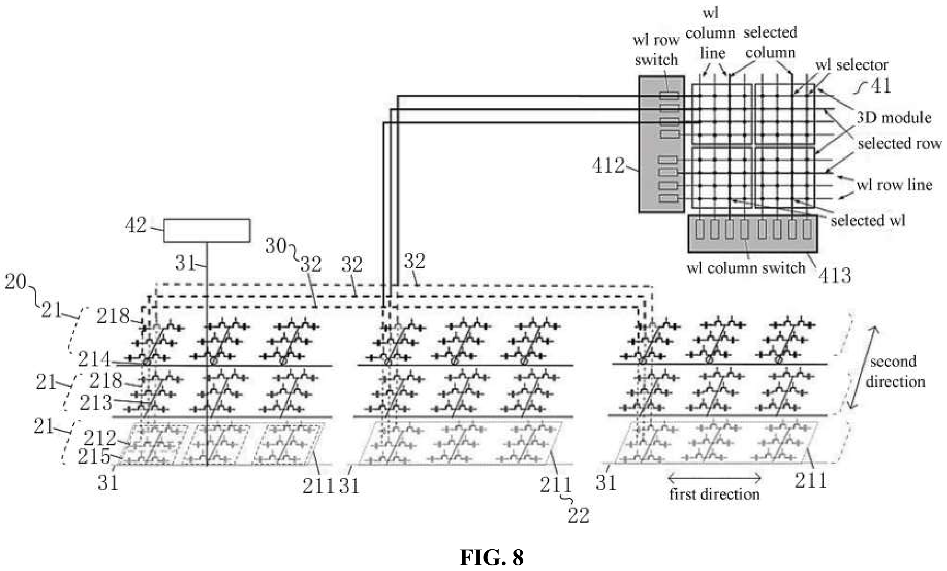

In some optional implementations of the present disclosure, as illustrated in FIG. 6 and 8, the sub-memory array 211 has at least two memory cell columns 215. The at least two memory cell columns 215 are sequentially arranged along the first direction, facilitating the arrangement and avoiding interference.

In some optional implementations of the present disclosure, as illustrated in FIG. 6 and FIG. 8, at least two memory cell columns 215 of the same sub-memory array 211 are electrically connected to the same corresponding shared bit line 31. Through the same shared bit line 31, data can be read from or written to the memory cells 212 in at least two memory cell columns 215 of the same sub-memory array 211, which simplifies the structure of the wiring portion 30, helps save peripheral circuit area, and improves device density and integration.

In some optional implementations of the present disclosure, as illustrated in FIG. 8, FIG. 9, and FIG. 10, among at least two memory cell columns 215 of the same sub-memory array 211, different memory cell columns 215 are correspondingly connected to different shared word lines 32. The shared word lines 32 correspondingly connected to different memory cell columns 215 are located in different wiring layers 33, and at least two wiring layers 33 correspondingly connected to at least two memory cell columns 215 are sequentially arranged along a direction perpendicular to the substrate.

For example, as illustrated in FIG. 8, FIG. 9, and FIG. 10, among at least two memory cell columns 215 of the same sub-memory array 211, the gates of transistors of memory cells 212 located at the same corresponding positions in different memory cell columns 215 are respectively connected to different shared word lines 32. Moreover, the shared word lines 32 that are respectively connected to the gates of transistors in memory cells 212 located at the same corresponding positions in different memory cell columns 215, are located in different wiring layers 33. The at least two wiring layers 33 that are respectively connected to the at least two memory cell columns 215, are arranged sequentially along a direction perpendicular to the substrate.

If all the shared word lines are arranged in the same wiring layer, it would increase the area of this wiring layer, thereby reducing the extent of the reduction in peripheral circuit area. Therefore, in the embodiments of the present disclosure, in order to range the shared word lines 32 apart, the number of wiring layers 33 needs to be increased, so that the area of each wiring layer 33 is relatively small, thereby saving peripheral circuit area.

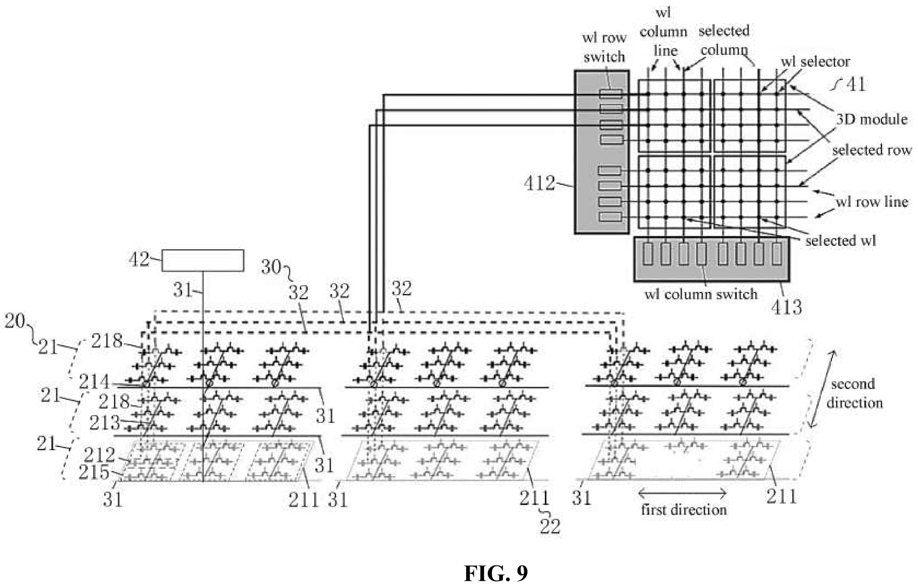

As illustrated in FIG. 8 and FIG. 9, each shared bit line 31 includes interconnected horizontal shared bit line and vertical shared bit line. The horizontal shared bit line is connected to the gating structure 214, and the vertical shared bit line is connected to the sense amplifier (SA) circuit 42 of the peripheral circuit portion 40. The horizontal shared bit line may be parallel to the substrate, for example, parallel to the first direction. The vertical shared bit lines may be perpendicular to the substrate.

Optionally, as illustrated in FIG. 8, each horizontal shared bit line is connected to the SA circuit 42 of one peripheral circuit portion 40 through one vertical shared bit line. Alternatively, as illustrated in FIG. 9, multiple horizontal shared bit lines (illustrated with three lines in FIG. 9) whose orthographic projections on the substrate overlap with each other are connected to one vertical shared bit line (i.e., multiple horizontal shared bit lines whose orthographic projections on the substrate overlap with each other share one vertical shared bit line), and are connected to the SA circuit 42 of the peripheral circuit portion through this one vertical shared bit line.

It should be understood that, FIG. 8, FIG. 9, and FIG. 10 also illustrate word line (wl) row switches, wl column switches, wl column lines, selected columns, wl row lines, wl selectors, 3D modules, selected rows, and selected wls, where wl is the abbreviation of word line.

Optionally, in embodiments of the present disclosure, when each sub-memory array 211 includes multiple memory cell columns 215, and is connected to the peripheral circuit portion 40 through the shared word line 32, the number of columns of transistors in the word line driver circuit (composed of multiple transistor arrays) in the corresponding peripheral circuit portion 40 needs to be increased.

In some optional implementations of the present disclosure, as illustrated in FIG. 1a, FIG. 1b, FIG. 4, and FIG. 5, the memory cell 212 includes a first transistor 216 and a second transistor 217. The source or drain of the first transistor 216 and the source or drain of the second transistor 217 are both electrically connected to the local bit line 213. The shared word line 32 correspondingly connected to the memory cell 212 includes a first sub-shared word line 321 and a second sub-shared word line 322. The first sub-shared word line 321 is electrically connected to the gate of the first transistor 216, and the second sub-shared word line 322 is electrically connected to the gate of the second transistor 217. The first sub-shared word line 321 and the second sub-shared word line 322 are located in the same wiring layer 33. Within this wiring layer 33, the first sub-shared word line 321 and the second sub-shared word line 322 are arranged at intervals along the second direction and are staggered in the first direction.

The expression "the first sub-shared word line 321 and the second sub-shared word line 322 are staggered in the first direction" may refer to that: the first sub-shared word line 321 and the second sub-shared word line 322 are alternately arranged in the first direction, i.e., the first sub-shared word line 321 and the second sub-shared word line 322 are not aligned with each other.

Through this design, different sub-shared word lines correspondingly connected to different transistors in the same memory cell 212 can all be arranged in the same wiring layer 33. The staggered arrangement of different sub-shared word lines facilitates their convenient and reasonable placement in the same wiring layer 33, allowing all sub-shared word lines connected to different transistors of the same memory cell 212 to be placed in just one wiring layer.

It should be understood that FIG. 1a and FIG. 1b respectively illustrate the connection relationships between different transistors of the memory cell 212 in the same memory array 22, and the shared word line as well as the peripheral circuit portion 40. FIG. 1a illustrates the connection relationship between the first transistor 216 of the memory cell 212 in the memory array 22, and the shared word line as well as the peripheral circuit portion 40. FIG. 1b illustrates the connection relationship between the second transistor 217 of the memory cell 212 in the memory array 22, and the shared word line as well as the peripheral circuit portion 40.

Optionally, as illustrated in FIG. 1a, FIG. 1b, and FIG. 2, in the embodiments of the present disclosure, the first transistor 216 and the second transistor 217 of the memory cell 212 share one source or drain, which is referred to as a shared source or drain. This shared source or drain is electrically connected to the local bit line 213, and is further electrically connected to a corresponding shared bit line 31 sequentially through the local bit line 213 and the gating structure 214..

In some optional implementations of the present disclosure, as illustrated in FIG. 8, FIG. 9, and FIG. 10, at least two sub-memory arrays 211 are located in the same memory array layer 21. The memory portion 20 has multiple memory array layers 21, which are stacked sequentially in a direction perpendicular to the substrate. The multiple memory array layers 21 may satisfy at least one of the following conditions:
among the multiple memory array layers 21, the respective sub-memory arrays 211 whose orthographic projections on the substrate overlap are electrically connected to the same shared word line 32 or to different shared word lines 32; and
among the multiple memory array layers 21, the gates of the transistors of the respective memory cells 212 whose orthographic projections on the substrate overlap are electrically connected to the same shared word line 32.

In the embodiments of the present disclosure, the memory portion 20 has multiple memory array layers 21, and each memory array layer 21 is provided with at least two sub-memory arrays 211. The multiple memory array layers 21 are stacked sequentially in a direction perpendicular to the substrate. This design enables the semiconductor device 100 to form a three-dimensional (3D) stacked structure, which can improve storage capacity, reduce storage costs, improve integration and storage density, and facilitate miniaturization. Furthermore, this design can reduce the number of bit lines and word lines, which is beneficial for layout design, improving structural density, and enhancing practicality.

In the embodiments of the present disclosure, among the multiple memory array layers 21, respective sub-memory arrays 211 whose orthographic projections on the substrate overlap are electrically connected to the same shared bit line 31. That is, among sub-memory arrays 211 located in different memory array layers 21, respective sub-memory arrays 211 whose orthographic projections on the substrate overlap can share the same shared bit line 31. Among the multiple memory array layers 21, the gates of transistors of respective memory cells 212 whose orthographic projections on the substrate overlap are electrically connected to the same shared word line 32. That is, among memory cells 212 in sub-memory arrays 211 located in different memory array layers 21, the transistors of respective memory cells 212 whose orthographic projections on the substrate overlap can share the same shared word line 32.

This design enables multiple memory array layers 21, multiple sub-memory arrays 211, and multiple memory cells 212 of the semiconductor device 100 to operate simultaneously, realizing bit line sharing and word line sharing, thereby minimizing peripheral circuit area. Furthermore, when the memory portion 20 adopts a three-dimensional structure with multiple memory array layers 21, the arrangement of the wiring portion 30 and peripheral circuit portion 40 is not affected.

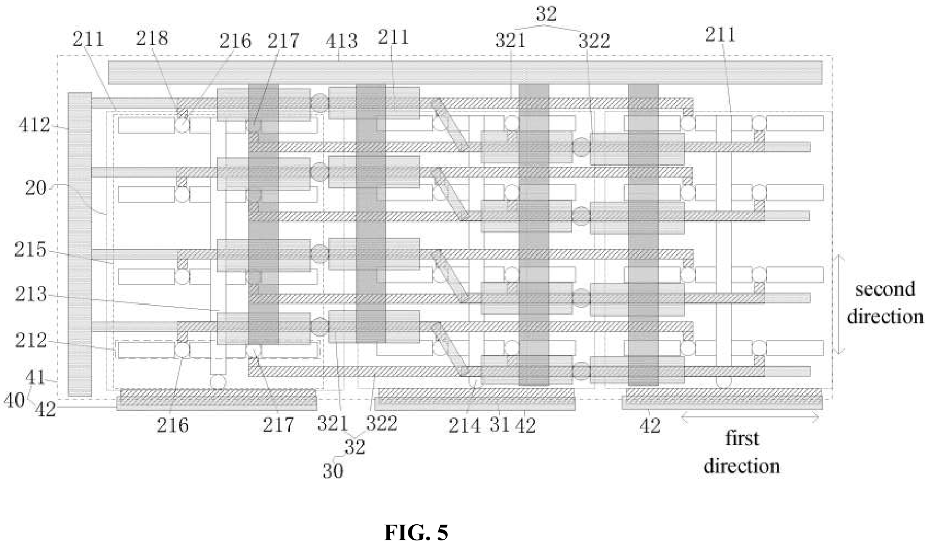

In some optional implementations of the present disclosure, as illustrated in FIG. 2 and 5, the peripheral circuit portion 40 includes a word line driver circuit 41, which may also be referred to as a sub-word line driver (SWD) circuit. The shared word line 32 is electrically connected to the word line driver circuit 41. The orthographic projection of the word line driver circuit 41 on the substrate and the orthographic projection of the shared word line 32 on the substrate both overlap with the orthographic projection of the correspondingly connected memory cell 212 on the substrate.

In the embodiments of the present disclosure, the word line driver circuit 41 is electrically connected to the shared word line 32, and the word line driver circuit 41 provides a word line voltage for the shared word line 32. The orthographic projection of the word line driver circuit 41 on the substrate, the orthographic projection of the shared word line 32 on the substrate, and the orthographic projection of the corresponding memory cell 212 on the substrate overlap with each other. The word line driver circuit 41, the shared word line 32, and the corresponding memory cell 212 are sequentially arranged in a direction perpendicular to the substrate, such that these three components-the word line driver circuit 41, the shared word line 32, and the corresponding memory cell 212-are located within the same area on different layers, without occupying additional area, thus saving wiring and peripheral circuit area.

Moreover, compared with conventional technology where one transistor is connected to the peripheral circuit through one word line, the embodiments of the present disclosure can significantly reduce SWD circuit area by using shared word lines, without occupying additional area, thereby improving device density and integration.

Optionally, in the embodiments of the present disclosure, memory portion 20, wiring layer 33, and word line driver circuit 41 are arranged from bottom to top. That is, word line driver circuit 41 is located directly above wiring layer 33, and the wiring layer 33 is located directly above memory portion 20. As illustrated in FIG. 1b and FIG. 5, the word line driver circuit 41 (SWD circuit) includes a first word line driver circuit 412 (SWDx), a second word line driver circuit 413 (SWDy), and a transistor array. This transistor array includes multiple transistors arranged in an array. SWDx is connected to the gates of multiple transistors in the transistor array, and SWDy is connected to the sources or drains of multiple transistors in the transistor array.

In some optional implementations of the present disclosure, different transistors of one memory cell 212 in one sub-memory array 211 are respectively connected to different shared word lines 32, these different shared word lines 32 are respectively connected to different positions of the same word line driver circuit 41. Specifically, the shared word line connected to the left transistor (e.g., the first transistor 216 in FIG. 1a) of the memory cell 212 is connected to the left transistor array of the peripheral circuit portion 40; and the shared word line connected to the right transistor (e.g., the second transistor 217 in FIG. 1b) of the memory cell 212 is connected to the right transistor array of the peripheral circuit portion 40. This arrangement enables different shared word lines 32 respectively connected to different transistors of the same memory cell 212 to share the same word line driver circuit 41.

In some optional implementations of the present disclosure, as illustrated in FIG. 1a and FIG. 1b, FIG. 1a illustrates that the first transistor 216 is connected to the word line driver circuit 41 through the first sub-shared word line 321, and FIG. 1b illustrates that the second transistor 217 is connected to the word line driver circuit 41 through the second sub-shared word line 322. The first sub-shared word line 321 and the second sub-shared word line 322, which are respectively connected to the first transistor 216 and the second transistor 217 of the same memory cell 212, are connected to different positions of the same word line driver circuit 41. Thus, the first sub-shared word line 321 and the second sub-shared word line 322, which are respectively connected to the first transistor 216 and the second transistor 217 of the same memory cell 212, can share the same word line driver circuit 41.

In some optional implementations of the present disclosure, as illustrated in FIG. 2, there are multiple sub-memory arrays 211. The multiple sub-memory arrays 211 sequentially arranged along the first direction are grouped into at least two memory arrays 22. The gates of transistors of memory cells 212 located at the same corresponding positions in respective sub-memory array 211 of the same memory array 22 are electrically connected to the same shared word line 32. That is, the gates of transistors of memory cells 212 located at the same corresponding positions in respective sub-memory array 211 of the same memory array 22 can share one shared word line 32. By electrically connecting to the word line driver circuit 41 through this shared word line 32, the wiring can be significantly reduced, the peripheral circuit area can be decreased, and the device density and integration can be improved.

In some optional implementations of the present disclosure, as illustrated in FIG. 2, the gates of transistors of memory cells 212 located at the same corresponding positions in sub-memory arrays 211 of different memory arrays 22 are electrically connected to the same shared word line 32. By sharing one shared word line 32, the wiring can be significantly reduced, the peripheral circuit area can be decreased, and the device density and integration can be improved.

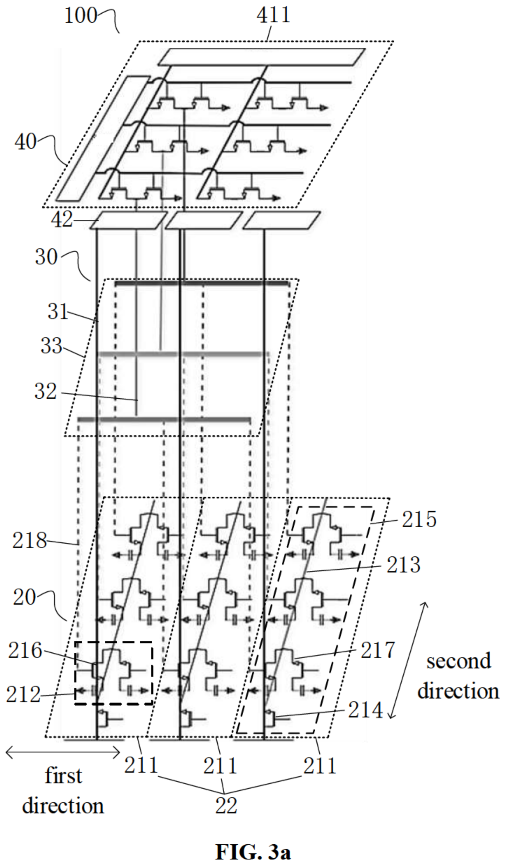

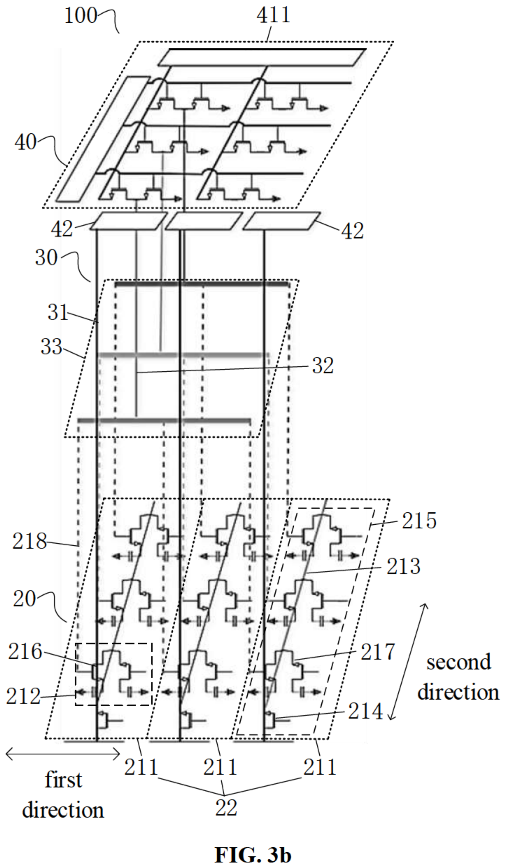

In some optional implementations of the present disclosure, as illustrated in FIG. 3a and FIG. 3b, the gates of transistors of memory cells 212 located at the same corresponding positions in sub-memory arrays 211 of different memory arrays 22 are respectively electrically connected to different shared word lines 32, thereby avoiding interference.

In some optional implementations of the present disclosure, as illustrated in FIG. 3a and FIG. 3b, the gates of transistors of memory cells 212 located at the same corresponding positions in sub-memory arrays 211 of different memory arrays 22 are respectively electrically connected to different shared word lines 32, thereby avoiding interference. The word line driver circuit 41 includes at least two sub-word line driver circuits 411, and the at least two sub-word line driver circuit 411 are connected to at least one memory array 22 in a one-to-one correspondence.

In the embodiments of the present disclosure, each memory array 22 is electrically connected to a corresponding sub-word line driver circuit 411 through a corresponding shared word line 32, thereby avoiding interference. Furthermore, this arrangement enables multiple memory arrays 22, multiple sub-memory arrays 211, and multiple memory cells 212 of the semiconductor device 100 to operate simultaneously, achieving bit line sharing and word line sharing, thereby minimizing the area of the peripheral circuit portion 40.

In the embodiment of the present disclosure, as illustrated in FIG. 2, at least two shared word lines 32, which are respectively electrically connected to the gates of transistors of memory cells 212 located at corresponding positions in sub-memory arrays 211 of different memory arrays 22, are located in the same wiring layer 33 or in different wiring layers 33. By arranging at least two shared word lines 32 in the same wiring layer, wiring can be reasonable arranged, simplifying the structure of the wiring portion 30, avoiding clutter, and helping to save peripheral circuit area and improving device density and integration.

In some optional implementations of the present disclosure, at least two shared word lines 32, which are respectively electrically connected to the gates of transistors of memory cells 212 at different corresponding positions in sub-memory arrays 211 of different memory arrays 22, are located in the same wiring layer 33. This design approach enables reasonable wiring arrangement, simplifies the structure of the wiring portion 30, avoids clutter, helps save peripheral circuit area, and improves device density and integration.

As described above, "the transistors of memory cells 212 located at the same corresponding positions in different sub-memory arrays 211 among the at least two sub-memory arrays 211" in the embodiments of the present disclosure include transistors of all memory cells 212 with coordinates (M, N) located in different sub-memory arrays 211 among the at least two sub-memory arrays 211. For example, taking the memory portion 20 including two sub-memory arrays 211, and each sub-memory array 211 including four memory cells 212 arranged in an array as an example. Among the two sub-memory arrays 211, the transistors of the memory cells 212 located at the same corresponding positions in different sub-memory arrays 211 include:
the transistors of the memory cells 212 with coordinates (1,1) in the two sub-memory arrays 211, that is, the transistors of the memory cells 212 located in the first row and the first column in the two sub-memory arrays 211; or,
the transistors of the memory cells 212 with coordinates (1,2) in the two sub-memory arrays 211, that is, the transistors of the memory cells 212 located in the first row and the second column in the two sub-memory arrays 211; or,
the transistors of the memory cells 212 with coordinates (2,1) in the two sub-memory arrays 211, that is, the transistors of the memory cells 212 located in the second row and the first column in the two sub-memory arrays 211; or,
the transistors of the memory cells 212 with coordinates (2,2) in the two sub-memory arrays 211, that is, the transistors of the memory cells 212 located in the second row and the second column in the two sub-memory arrays 211.

It should be understood that, in the embodiments of the present disclosure, the term "gates of transistors of memory cells 212 located at different corresponding positions in sub-memory arrays 211 of different memory arrays 22" includes the gates of transistors of memory cells 212 with different coordinates in sub-memory arrays 211 of different memory arrays 22. Here, the description is still made by taking the memory portion 20 including two sub-memory arrays 211, and each sub-memory array 211 including four memory cells 212 arranged in an array as an example. The transistors of memory cells 212 with different coordinates located in sub-memory arrays 211 of different memory arrays 22 include: the transistor of the memory cell 212 with coordinates (1, 1) in the sub-memory array 211 of one memory array 22, and the transistors of the memory cells 212 with coordinates (1, 2), (2, 1), and/or (2, 2) in the sub-memory array 211 of another memory array 22.

It should be understood that the meaning of "different corresponding positions" in the following description in the embodiments of the present disclosure is similar to the above explanation of the meaning of "different corresponding positions", and will not be repeated here.

In other optional implementations of the present disclosure, at least two shared word lines 32, which are respectively electrically connected to memory cells 212 located at different corresponding positions in sub-memory arrays 211 of different memory arrays 22, are respectively located on different wiring layers 33. This design approach enables reasonable wiring arrangement, allowing the shared word lines 32 to be arranged separately, thus reducing the area of each wiring layer 33, saving the area of the peripheral circuit portion 40, and improving device density and integration.

In other optional implementations of the present disclosure, as illustrated in FIG. 2, when there are multiple different memory arrays 22, they may also be connected to the same word line driver circuit 41 through shared word lines 32. That is, there are multiple sub-memory arrays 211, and multiple sub-memory arrays 211 arranged sequentially along a first direction are grouped into at least two memory arrays 22. The gates of transistors of memory cells 212 located at the same corresponding positions in multiple sub-memory arrays 211 of different memory arrays 22 may be connected together through shared word lines 32 and may be further connected to the corresponding word line driver circuit 41. Multiple shared word lines 32, which are respectively connected to memory cells 212 in corresponding sub-memory arrays 211 of the memory portion 20, are electrically connected to the same word line driver circuit 41. This arrangement enables multiple sub-memory arrays 211 to share one word line driver circuit 41, significantly reducing the area of the word line driver circuit 41. In other words, the word line driver circuit 41 can save area through word line sharing.

For example, as illustrated in FIG. 2, there are two memory arrays 22 from left to right (three or more memory arrays 22 are optional). Each memory array 22 includes two sub-memory arrays 211 (three or more sub-memory arrays 211 are optional). Each sub-memory array 211 has only one layer of memory cells 212 (two or more layers of memory array layers 21 are optional). Each sub-memory array 211 has one memory cell column 215 (two or more memory cell columns 215 are optional). Each memory cell column 215 has 2×2 1T1C bits (multiple 1T1C bits are optional). Here, a 1T1C bit refers to one transistor (T) and one capacitor (C).

Two 1T1C bits arranged along the first direction form a memory cell 212. The memory cell column 215 of each sub-memory array 211 shares one shared bit line 31. The gates of transistors (i.e., the first transistor 216 and second transistor 217 mentioned earlier) of the two 1T1C bits in the same memory cell 212 are respectively electrically connected to two shared word lines 32. These two shared word lines 32 are located in the same wiring layer 33, arranged at intervals along the second direction within this wiring layer 33, and staggered in the first direction. The transistors of the two 1T1C bits arranged along the second direction are respectively electrically connected to the two shared word lines 32. These two shared word lines 32 are located in the same wiring layer 33, and arranged at intervals along the second direction within this wiring layer 33. The 1T1C bits located at the same corresponding positions in the two sub-memory arrays 211-such as the two left 1T1C bits in the two memory cells 212 arranged along the first direction, both having coordinates (1, 1)-are electrically connected to the same shared word line 32, and further electrically connected to the corresponding word line driver circuit 41 through this shared word line 32.

When there are multiple different memory arrays 22, they may also be connected to the array bits in the same peripheral circuit portion 40 through shared word lines 32. Herein, an array bit refers to multiple bits arranged in an array, and a bit refers to a shared source or drain of two transistors in the peripheral circuit portion 40.

As illustrated in FIG. 2, the peripheral circuit array region includes the sense amplifier circuits 42 (SA circuits) and the word line driver circuit 41 (SWD circuit). The SA circuit 42 is located directly above the shared word line 32 and the step metal lines, and is connected to the gating structure 214 through the shared bit line 31. The SWD circuit 41 includes multiple transistor arrays. This region is located directly above the memory portion 20 and the wiring portion 30. The shared source or drain of every two transistors is connected to the shared word line 32 at the corresponding position below, and the shared word line 32 is connected to the word line (WL) of the memory array 22 at the corresponding position.

The gate structure 214 is a transistor, whose gate is connected to different bits of the SWD circuit 41, i.e., different shared sources or drains of the SWD circuit 41.

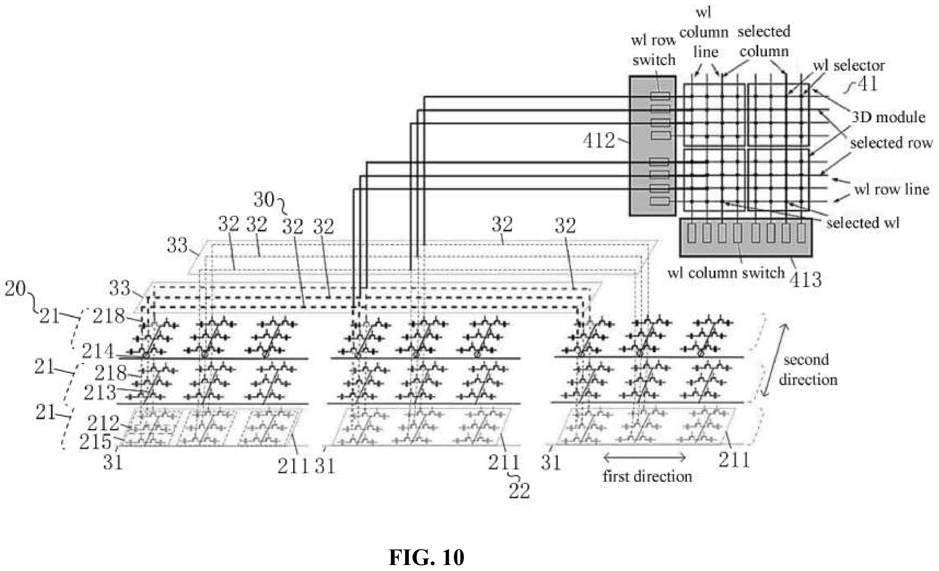

In some optional implementations of the present disclosure, as illustrated in FIG. 7, FIG. 8, and FIG. 9, the word line driver circuit 41 of the peripheral circuit portion 40 includes multiple sites arranged in a matrix. Shared word lines 32 in the same layer are respectively connected to different sites in the same column of the word line driver circuit 41. As illustrated in FIG. 10, shared word lines 32 of different layers are respectively connected to sites in different columns of the word line driver circuit 41. Here, a site refers to the shared source or drain of two transistors in the transistor array.

In some optional implementations of the present disclosure, as illustrated in FIG. 1a, FIG. 1b, and FIG. 2, the peripheral circuit portion 40 further includes at least two sense amplifier circuits 42 (SA circuits) which are connected to at least two shared bit lines 31 in a one-to-one correspondence. The orthographic projection of the sense amplifier circuit 42 on the substrate overlaps with the orthographic projection of the correspondingly connected shared bit line 31 on the substrate.

In the embodiments of the present disclosure, at least two sense amplifier circuits 42 are connected to at least two shared bit lines 31 in a one-to-one correspondence. The sense amplifier circuit 42 can sense and amplify data received from the corresponding shared bit line 31, or transmit data to the corresponding shared bit line 31. The orthographic projection of the sense amplifier circuit 42 on the substrate overlaps with the orthographic projection of the correspondingly connected shared bit line 31 on the substrate. The sense amplifier circuits 42 and the corresponding connected shared bit lines 31 are arranged sequentially in a direction perpendicular to the substrate, such that the sense amplifier circuits 42 and the corresponding connected shared bit lines 31 are located within the same area on different layers, without occupying additional area, thereby saving wiring and peripheral circuit area.

In the embodiment of the present disclosure, the peripheral circuit portion 40 includes SA circuits 42 and SWD circuit 41. The SA circuits 42 are located directly above shared bit line 31 and are interconnected. The SWD circuit 41 is composed of multiple transistor arrays and is located directly above the memory portion 20 and the wiring layer 33. Through this wiring method and structure, the memory portion 20, the wiring portion 30, and the peripheral circuit portion 40 are located within the same area on different layers, without occupying additional area, thereby saving wiring and peripheral circuit area.

In some optional implementations of the present disclosure, as illustrated in FIG. 1a, FIG. 1b, and FIG. 2, the memory portion 20, the wiring portion 30, and the peripheral circuit portion 40 are sequentially arranged in the direction away from the substrate. As illustrated in FIG. 5, the peripheral circuit portion 40 is located on top of the memory portion 20. Specifically, the wiring portion 30 is located on top of the memory portion 20, and the peripheral circuit portion 40 is located on top of the wiring portion 30.

Of course, in other optional implementations of the present disclosure, the peripheral circuit portion 40, the wiring portion 30, and the memory portion 20 are sequentially arranged in the direction away from the substrate. The peripheral circuit portion 40 is located at the bottom of the wiring portion 30, and the wiring portion 30 is located at the bottom of the memory portion 20.

The embodiment of present disclosure provides a semiconductor device. In this semiconductor device, the gates of transistors located at the same corresponding positions in different sub-memory arrays, or word lines connected to these gates, are connected together through shared word lines, and then commonly connected to a word line driver circuit, enabling one word line driver circuit in the peripheral circuit portion to control multiple memory bits. By sharing word lines among different sub-memory arrays, the area occupied by the word line driver circuitry is reduced. The shared word lines are designed such that the word lines of the left bits and right bits of the memory cells of each memory cell column of the sub-memory array are respectively connected to staggered shared word lines. This allows the wiring layer to be placed directly above the memory array, the word line driver circuit to be placed above the wiring layer, and the sense amplifier circuit to be placed above the shared bit lines, thereby saving peripheral circuit area. Through reasonable circuit design, word lines or bit lines in different memory arrays are merged and connect to the word line driver circuit or sense amplifier circuit, which can significantly reduce the area occupied by the word line driver circuit or sense amplifier circuit.

Through the structure of shared word lines and bit lines, and by designing the wiring structure, the shared bit lines and shared word lines are respectively connected to the SA circuit and SWD circuit. This enables the local bit lines of sub-memory arrays in different layers to share one SA circuit, and the word lines of memory cells in different columns to share the same one SWD circuit, which can significantly reduce the area of the SWD circuit. Furthermore, by placing the metal wirings and peripheral circuit portion directly above the memory array, no additional area is occupied, thereby improving device integration density.

The embodiment of present disclosure provides a semiconductor device, which belongs to the field of semiconductor device fabrication. It is suitable for three-dimensional transistor memory and can be applied to the connection structure and connection method of the three-dimensional memory storage array structures and peripheral circuits. Naturally, the semiconductor device may also be a random access memory, specifically a static random access memory or a dynamic random access memory, and may also be flash memory, etc.

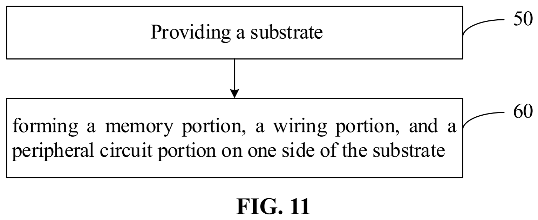

Based on the same inventive concept, the embodiment of the present disclosure provides a method for preparing a semiconductor device, which can prepare the semiconductor device provided in the above embodiments. As illustrated in FIG. 11, the method includes the following operations.

In operation 50: a substrate is provided.

In operation 60: the memory portion, wiring portion, and peripheral circuit portion are form on one side of the substrate.

Specifically, in the direction perpendicular to the substrate, the memory portion, wiring portion, and peripheral circuit portion are located at different positions. The memory portion includes at least two sub-memory arrays arranged sequentially along a first direction parallel to the substrate. Each sub-memory array includes at least one memory cell, and each memory cell includes a transistor.

The wiring portion includes at least one shared word line. Among the at least two sub-memory arrays, the gates of transistors of memory cells located in different sub-memory arrays are electrically connected to the same shared word line, and the shared word line is connected to the peripheral circuit portion.

It should be understood that the semiconductor device preparation method according to the embodiment of the present disclosure can be used to prepare the semiconductor device according to the above embodiments. Therefore, this preparation method also has the aforementioned beneficial effects of the semiconductor device according to the embodiment of the present disclosure, which will not be repeated here.

Based on the same inventive concept, the embodiment of the present disclosure provides an electronic device, which includes the semiconductor device 100 according to the above embodiments.

It should be understood that since the electronic device according to the embodiment of the present disclosure includes the semiconductor device according to the embodiment of the present disclosure, the electronic device according to the embodiment of the present disclosure also has the aforementioned beneficial effects of the semiconductor device according to the embodiment of the present disclosure, which will not be repeated herein.

In some optional implementations of the present disclosure, the electronic device may include a storage device, a smartphone, a computer, a tablet computer, an artificial intelligence device, a wearable device, or a power bank, etc. The storage device may include such as a memory in a computer, which is not limited herein.

Applying the embodiments of the present disclosure can achieve at least the following beneficial effects.

In the embodiments of the present disclosure, the memory portion, the wiring portion, and the peripheral circuit portion are located at different positions in the direction perpendicular to the substrate. This allows the memory portion, the wiring portion, and the peripheral circuit portion to be arranged at different positions in the direction perpendicular to the substrate, facilitating reasonable space allocation and reducing the occupied area. At least two sub-memory arrays of the memory portion are arranged sequentially along a first direction parallel to the substrate, which facilitates the arrangement of at least two sub-memory arrays and can avoid interference.

In the embodiments of the present disclosure, each sub-memory array includes at least one memory cell. The wiring portion includes at least one shared word line, and the at least one shared word line is in one-to-one correspondence with at least one memory cell in each sub-memory array. Furthermore, among at least two sub-memory arrays, the gates of transistors of memory cells located in different sub-memory arrays are electrically connected to the same shared word line. That is, among at least two sub-memory arrays of the memory portion, the gates of transistors of memory cells located in different sub-memory arrays can share one shared word line, and can be connected to the peripheral circuit portion through this shared word line. Through the shared word line, the embodiment of the present disclosure can significantly reduce wiring and decrease peripheral circuit area, avoiding additional area occupation, improving device density and integration.

In the embodiment of the present disclosure, at least two shared bit lines of the wiring portion are connected to at least two sub-memory arrays in one-to-one correspondence, and different sub-memory arrays are respectively connected to different shared bit lines in one-to-one correspondence. Through the shared bit lines, data can be read from memory cells in the corresponding sub-memory array or written into memory cells in the corresponding sub-memory array. Among multiple memory array layers, respective sub-memory arrays whose orthographic projections on the substrate overlap are electrically connected to the same shared bit line. That is, among sub-memory arrays located in different memory array layers, respective sub-memory arrays whose orthographic projections on the substrate overlap can share the same shared bit line. Among multiple memory array layers, transistors of respective memory cells whose orthographic projections on the substrate overlap are electrically connected to the same shared word line. That is, among memory cells in sub-memory arrays located on different memory array layers, transistors of respective memory cells whose orthographic projections on the substrate overlap can share the same shared word line. This design enables multiple memory array layers, multiple sub-memory arrays, and multiple memory cells of the semiconductor device to operate simultaneously, achieving bit line sharing and word line sharing, thereby minimizing peripheral circuit area. Furthermore, when the memory portion adopts a three-dimensional structure with multiple memory array layers, the arrangement of the wiring portion and peripheral circuit portion is not affected.

The orthographic projection of the word line driver circuit on the substrate, the orthographic projection of the shared word line on the substrate, and the orthographic projection of the corresponding memory cell on the substrate overlap with each other, such that these three components-the word line driver circuit, the shared word line, and the corresponding memory cell-are located within the same area on different layers, without occupying additional area, thus saving wiring and peripheral circuit area. Furthermore, the embodiments of the present disclosure can significantly reduce the word line driver circuit area by using shared word lines, without occupying additional area, thereby improving device density and integration.

The orthographic projection of the sense amplifier circuit on the substrate overlaps with the orthographic projection of the correspondingly connected shared bit line on the substrate, such that the sense amplifier circuits and the corresponding connected shared bit lines are located within the same area on different layers, without occupying additional area, thereby saving wiring and peripheral circuit area.

Through the above wiring method and structure, the memory portion, wiring portion, and peripheral circuit portion are located within the same area on different layers without occupying other additional areas, thereby saving wiring and peripheral circuit area.

Those skilled in the art should be understand that the steps, measures, and schemes in the various operations, methods, and processes discussed in the present disclosure can be alternated, modified, combined, or deleted. Further, other steps, measures, and schemes in the various operations, methods, and processes discussed in the present disclosure can also be alternated, modified, rearranged, decomposed, combined, or deleted. Further, steps, measures, and schemes in the prior art that are similar to those disclosed in the various operations, methods, and processes in the present disclosure can also be alternated, modified, rearranged, decomposed, combined, or deleted.

In the description of the present disclosure, the terms such as "center", "up", "down", "front", "back", "left", "right", "vertical", "top", "bottom", "inside" and "outside" indicate directional or positional relationships based on the exemplary orientations illustrated in the drawings. They are intended to facilitate the description or simplify the description of the embodiments of the present disclosure, and do not indicate or imply that the referenced device or component must have a specific orientation, be constructed and operated in a specific orientation, and thus cannot be construed as limiting the present disclosure.

The terms "first" and "second" are used solely for descriptive purposes and should not be understood as indicating or implying relative importance or as implying the number of technical features indicated. Accordingly, features defined as "first" or 'second' may explicitly or implicitly include one or more such features. In the description of the present disclosure, unless otherwise specified, "multiple" means two or more.

In the description of the present disclosure, it should be noted that unless otherwise explicitly defined and limited, the terms "mounted," "connected," and "coupled" should be understood broadly. For example, they may refer to fixed connections, removable connections, or integral connections; they may indicate direct connections or indirect connections through intermediate media; and they may denote internal communication between two components. Those skilled in the art will understand the specific meaning of the above terms in the context of the disclosure based on the particular circumstances.

In the description of this specification, specific features, structures, materials, or characteristics may be combined in any suitable manner in any one or more embodiments or examples.

The above are only partial implementations of the present disclosure. It should be noted that for those of ordinary skill in the art, without departing from the technical concept of the present disclosure, other similar implementation means based on the technical ideas of the present disclosure also fall within the protection scope of the embodiments of the present disclosure.

## Claims

1. A semiconductor device, comprising: a substrate; and a memory portion, a wiring portion, and a peripheral circuit portion disposed on one side of the substrate;
wherein the memory portion, the wiring portion, and the peripheral circuit portion are located at different positions in a direction perpendicular to the substrate;
the memory portion comprises at least two sub-memory arrays arranged sequentially along a first direction parallel to the substrate;
each of the sub-memory arrays comprises at least one memory cell, and each memory cell comprises a transistor;
the wiring portion comprises at least one shared word line; and
among the at least two sub-memory arrays, gates of transistors in memory cells located in different sub-memory arrays are electrically connected to the same shared word line, and the shared word line is connected to the peripheral circuit portion.

2. The semiconductor device of claim 1, wherein gates of transistors in memory cells located at the same corresponding positions in the different sub-memory arrays are electrically connected to the same shared word line.

3. The semiconductor device of claim 1 or 2, wherein the wiring portion further comprises at least two shared bit lines, and the at least two shared bit lines are connected to the at least two sub-memory arrays in a one-to-one correspondence.

4. The semiconductor device of claim 3, wherein the sub-memory array comprises a local bit line, a gating structure, and a plurality of memory cells, and the plurality of memory cells are arranged sequentially along a second direction parallel to the substrate;
the local bit line is electrically connected to sources or drains of transistors in the plurality of memory cells, respectively, and the local bit line is electrically connected to the gating structure to form a memory cell column;
the gating structure is electrically connected to a corresponding shared bit line; and
the second direction intersects the first direction.

5. The semiconductor device of claim 4, wherein a plurality of shared word lines, which are connected to the plurality of memory cells in the same sub-memory array in a one-to-one correspondence, are located in a same wiring layer, the wiring layer is parallel to the substrate; and within the wiring layer, the plurality of shared word lines are sequentially arranged along the second direction.

6. The semiconductor device of claim 4, wherein the sub-memory array has at least two memory cell columns arranged sequentially along the first direction;
the at least two memory cell columns of the same sub-memory array are electrically connected to the same corresponding shared bit line; and
among the at least two memory cell columns of the same sub-memory array, shared word lines correspondingly connected to different memory cell columns are located in different wiring layers; and at least two wiring layers correspondingly connected to the at least two memory cell columns are sequentially arranged along the direction perpendicular to the substrate.

7. The semiconductor device of any one of claims 1 to 6, wherein the memory cell comprises a first transistor and a second transistor, and a source or drain of the first transistor and a source or drain of the second transistor are both electrically connected to a local bit line;
the shared word line correspondingly connected to the memory cell comprise a first sub-shared word line and a second sub-shared word line, the first sub-shared word line is electrically connected to a gate of the first transistor, and the second sub-shared word line is electrically connected to a gate of the second transistor; and
the first sub-shared word line and the second sub-shared word line are located in the same wiring layer; within the wiring layer, the first sub-shared word line and the second sub-shared word line are arranged at intervals along the second direction and are staggered in the first direction.

8. The semiconductor device of any one of claims 3 to 6, wherein the at least two sub-memory arrays are located in a same memory array layer, and the memory portion has a plurality of memory array layers stacked sequentially in the direction perpendicular to the substrate; the plurality of memory array layers satisfy at least one of following conditions:
among the plurality of memory array layers, respective sub-memory arrays whose orthographic projections on the substrate overlap are electrically connected to the same shared bit line; and
among the plurality of memory array layers, gates of transistors of respective memory cells whose orthographic projections on the substrate overlap are electrically connected to the same shared word line.

9. The semiconductor device of any one of claims 1 to 8, wherein the peripheral circuit portion comprises a word line driver circuit, and the shared word line is electrically connected to the word line driver circuit;
an orthographic projection of the word line driver circuit on the substrate and an orthographic projection of the shared word line on the substrate both overlap with an orthographic projection of the correspondingly connected memory cell on the substrate.

10. The semiconductor device of claim 9, wherein there are a plurality of sub-memory arrays, and the plurality of sub-memory arrays arranged sequentially along the first direction are grouped into the at least two memory arrays;
gates of transistors of memory cells located at the same corresponding positions in respective sub-memory arrays of the same memory array are electrically connected to the same shared word line; and
gates of transistors in memory cells located at the same corresponding positions in sub-memory arrays of different memory arrays are electrically connected to the same shared word line.

11. The semiconductor device of claim 9, wherein there are a plurality of sub-memory arrays, and the plurality of sub-memory arrays arranged sequentially along the first direction are grouped into the at least two memory arrays;
gates of transistors of memory cells located at the same corresponding positions in respective sub-memory arrays of the same memory array are electrically connected to the same shared word line; and
gates of transistors in memory cells located at the same corresponding positions in sub-memory arrays of different memory arrays are respectively electrically connected to different shared word lines.

12. The semiconductor device of claim 11, wherein the word line driver circuit comprises at least two sub-word line driver circuits, and the at least two sub-word line driver circuits are connected to the at least two memory arrays in a one-to-one correspondence.

13. The semiconductor device of claim 11 or 12, wherein at least two shared word lines, which are respectively electrically connected to the gates of the transistors in the memory cells located at the same corresponding positions in the sub-memory arrays of the different memory arrays, are located in the same wiring layer or in different wiring layers.

14. The semiconductor device of claim 7, wherein the peripheral circuit portion comprises a word line driver circuit, and the first sub-shared word line and the second sub-shared word line, which are respectively connected to the same memory cell, are respectively connected to different positions of the same word line driver circuit.

15. The semiconductor device of any one of claims 3 to 6, wherein the peripheral circuit portion further comprises at least two sense amplifier circuits connected to the at least two shared bit lines in a one-to-one correspondence;
an orthographic projection of each of the sense amplifier circuits on the substrate overlaps with an orthographic projection of the correspondingly connected shared bit line on the substrate.

16. The semiconductor device of claim 6, wherein the peripheral circuit portion comprises a word line driver circuit, and the word line driver circuit comprises a plurality of sites arranged in a matrix;
shared word lines located in the same wiring layer are respectively connected to different sites in the same column of the word line driver circuit, and shared word lines located in different wiring layers are respectively connected to sites in different columns of the word line driver circuit.

17. The semiconductor device of any one of claims 1 to 16, wherein
the memory portion, the wiring portion, and the peripheral circuit portion are sequentially arranged in a direction away from the substrate.

18. The semiconductor device of any one of claims 1 to 16, wherein the peripheral circuit portion, the wiring portion, and the memory portion are sequentially arranged in a direction away from the substrate.

19. A method for preparing a semiconductor device, comprising:
providing a substrate; and
forming a memory portion, a wiring portion, and a peripheral circuit portion on one side of the substrate;
wherein the memory portion, the wiring portion, and the peripheral circuit portion are located at different positions in a direction perpendicular to the substrate; the memory portion comprises at least two sub-memory arrays sequentially arranged along a first direction parallel to the substrate, each of the sub-memory arrays comprises at least one memory cell, and each memory cell comprises a transistor;
the wiring portion comprises at least one shared word line; among the at least two sub-memory arrays, gates of transistors in memory cells located in different sub-memory arrays are electrically connected to the same shared word line, and the shared word line is connected to the peripheral circuit portion.

20. An electronic device, comprising: the semiconductor device of any one of claims 1 to 18.
